# EUROPEAN PATENT APPLICATION

(11) **EP 4 123 721 A1**
(43) Date of publication of application: **25.01.2023**
(21) Application number: 21186564.7
(22) Date of filing: 20.07.2021
(51) Int. Cl.: H01L 29/417, H01L 21/285, H01L 29/778, H01L 29/45, H01L 29/20

(54) **SEMICONDUCTOR DEVICE STRUCTURE WITH RECESSED OHMIC CONTACTS AND METHOD FOR PRODUCING THE SAME**

(71) Applicant: SweGaN AB, 583 30 Linköping (SE)
(72) Inventor: Chen, Ding Yuan, 417 23 Göteborg (SE); Rorsman, Niclas, 413 21 Göteborg (SE); Chen, Jr-Tai, 583 71 Vikingstad (SE)
(74) Representative: AWA Sweden AB

(57) **Abstract**

The present disclosure relates to a semiconductor device structure (1) comprising: a substrate (10); a Group III-Nitride material channel layer (20) arranged on the substrate (10); a Group III-Nitride material barrier layer (30) arranged on the Group III-Nitride material channel layer (20); an ohmic contact structure (60) comprising a first Ti layer (61) and an Al layer (62) arranged on the first Ti layer (61), wherein the ohmic contact structure (60) is arranged recessed in the Group III-Nitride material barrier layer (30) such that the bottom of the first Ti layer (61) extends below a 2DEG channel level (2DEG) provided by the Group III-Nitride channel layer and Group III-Nitride material barrier layer (20, 30), the first Ti layer (61) provided with angled sidewalls (61a) with a sidewall angle 40° ≤ θ ≤ 75°, preferably 50° ≤ θ ≤ 60°, as measured as the angle (θ) between the respective angled sidewalls (61a) and a bottom of the Group III-Nitride material barrier layer (30); a thickness of the first Ti layer (61) is equal to or less than 5 nm; a thickness ratio between the first Ti layer (61) and the Al-layer (62) is Ti : Al < 1 : 1000, and a method of producing the same.

## Description

### Technical Field

The present disclosure relates to a semiconductor device structure with recessed ohmic contacts and a method for producing the same.

### Background

AlGaN/GaN high-electron-mobility transistors (HEMTs) are typically of interest for radio frequency, microwave, and power switching applications. Conventional AlGaN/GaN HEMTs are manufactured with Au-based ohmic contacts annealed at high temperatures, i.e. >800°C. Due to such a high annealing temperature, the Al of the AIGaN barrier layer is melted, resulting in poor surface morphology and edge acuity. Moreover, it is difficult to form ohmic contacts with low contact resistance on high Al content barrier layers since high Al content results in a larger barrier potential making it more difficult for electrons to be transported between the ohmic contacts and the 2DEG channel by thermionic transportation.

Several solutions have been proposed to the problem of forming ohmic contacts with low contact resistance on AlGaN/GaN HEMTs. Some of these solutions involve shallow recessed ohmic contacts (i.e. recessed to a depth above a 2DEG channel), or deeply recessed sidewall Ta-based ohmic contacts (i.e. recessed to a depth to or below a 2DEG channel).

By providing shallow recessed ohmic contacts in AlGaN/GaN HEMTs, the tunneling distance is reduced which consequently also reduces the contact resistance. However, this solution may introduce a non-uniform contact resistance which consequently degrades 2DEG properties.

Deeply recessed sidewall Ta-based ohmic contacts allow for the design of the barrier layer to be neglected and a large etching and lithography process windows can be achieved. This solution however introduces a series resistance between ohmic contacts and the 2DEG channel.

In view of the above, it is difficult to achieve manufacturing with high throughput with satisfying semiconductor properties.

Thus, there is a need for a semiconductor device structure comprising ohmic contacts with low contact resistance which at least alleviates the issues identified above with respect to conventional solutions.

### Summary

It is an object of the present invention to provide an improved solution that alleviates the mentioned drawbacks with present solutions. In particular, a first object to provide a semiconductor device structure comprising ohmic contacts with low contact resistance which is suitable for large scale manufacturing. This object is solved by the invention of claim 1. A second object is to provide a method for manufacturing such a semiconductor device structure which is suitable for large scale manufacturing. This object is solved by the method according to claim 7.

In the following, certain terminology is used. For instance, by a first layer A is "arranged on" a second layer B, it may mean that the first layer A is in direct contact with the second layer B or that there is one or more layers between the first layer A and the second layer B which do not prevent the semiconductor device structure from achieving a low contact resistance.

According to a first aspect of the invention, a semiconductor device structure is provided. The semiconductor device structure comprises: a substrate; a Group III-Nitride material channel layer arranged on the substrate; a Group III-Nitride material barrier layer arranged on the Group III-Nitride material channel layer; an ohmic contact structure comprising a first Ti layer and an Al layer arranged on the first Ti layer, wherein the ohmic contact structure is arranged recessed in the Group III-Nitride material barrier layer such that the bottom of the first Ti layer extends below a 2DEG channel level provided by the first Group III-Nitride material channel layer and the Group III-Nitride material barrier layer, the first Ti layer provided with angled sidewalls with a sidewall angle 40° ≤ θ ≤ 75°, preferably 50° ≤ θ ≤ 60°, as measured as the angle between the respective angled sidewalls and a bottom of the Group III-Nitride material barrier layer; a thickness of the first Ti layer is equal to or less than 5 nm; a thickness ratio between the first Ti layer and the Al-layer is Ti : Al < 1 : 1000.

By the specified sidewall angle, the tunneling distance is reduced which consequently also reduces the contact resistance. Moreover, by the first Ti layer extending below the 2DEG channel level, contact resistance is reduced further. Further, by the specified first Ti layer thickness, it may result in a lower contact resistance. Further, by using Ti instead of Ta in the ohmic contact structure, a lower contact resistance may be achieved. The thickness ratio Ti : Al < 1 : 1000 together with the sidewall angle feature provides the surprising advantage that the contact resistance can be further reduced, for example to an interval of 0.2 - 0.1 ohm-mm which normally can only be achieved by complicated regrowth ohmic contacts.

Thus, in view of the advantages mentioned above, the semiconductor structure device solves the first object mentioned above.

The sidewall angle θ is 40° ≤ θ ≤ 75° which allows a low contact resistance. By having a steeper sidewall angle than the specified range, it may result in the difficulty of metal deposition (poor metal coverage on the sidewall). Moreover, by having a small inclination than the specified range, it may result in degradation of 2DEG concentration at the interface region of semiconductor/ohmic metals (less electrons lead to bad contact resistance). Thus, the sidewall angle may be selected accordingly with respect of these aspects. Thus, the sidewall angle θ may be selected from any of the following 40° ≤ θ ≤ 45°, 45° ≤ θ < 50°, 50° ≤ θ ≤ 55°, 55° ≤ θ ≤ 60°, 60° ≤ θ ≤ 65°, 65° ≤ θ ≤ 70°, 70° ≤ θ ≤ 75°. As an example, when the semiconductor device structure comprises an AIGaN barrier layer, a contact resistance of 0.2 ohm-mm or lower may be achieved when the sidewall angle is 50° ≤ θ ≤ 60°. However, a low contact resistance of 0.2 ohm-mm can be achieved for 40° ≤ θ ≤ 50° and 60° ≤ θ ≤ 75° by changing e.g. material of the channel layer and/or barrier layer, thicknesses thereof, properties of the ohmic contact structure etc.

The substrate may be a SiC, Si, GaN, AIN, or sapphire substrate. In the case of a SiC substrate, the SiC substrate may have a polytype of 4H or 6C. The substrate may be provided so that the substrate off-cut angle is substantially zero along the in-plane lattice axes. The substrate may be doped with carbon. The substrate may be semi-insulating. The substrate may be pretreated in situ or ex situ by an etching gas, such as H₂, HCl, HF, HBr or SiF₄, Cl₂ or a combination of these, such as H₂ and any one of the other. By pretreatment of the substrate, the amount of e.g. oxygen and carbon contamination onto the substrate surface may be reduced.

The Group III-Nitride material channel layer may have a thickness of 0.050 - 10 µm. The Group III-Nitride material channel layer may have a thickness of 0.050 - 0.1 µm, 0.1 - 0.2 µm, 0.2 - 0.3 µm, 0.3 - 0.4 µm, 0.4 - 0.5 µm, 0.5 - 0.6 µm, 0.6 - 0.7 µm, 0.7 - 0.8 µm, 0.8 - 0.9 µm, 0.9 - 1.0 µm, 1.0 - 2.0 µm, 2.0 - 3.0 µm, 3.0 - 4.0 µm, 4.0 - 5.0 µm, 5.0 - 6.0 µm, 6.0 - 7.0 µm, 7.0 - 8.0 µm, 8.0 - 9.0 µm, or 9.0 - 10.0 µm.

The Group III-Nitride material barrier layer may have a thickness of 1-40 nm. The Group III-Nitride material barrier layer may have a thickness of 1 - 2 nm, 2 - 3 nm, 3 - 4 nm, 4 - 5 nm, 5 - 6 nm, 6 - 7 nm, 7 - 8 nm, 8 - 9 nm, 9 - 10 nm, 10 - 15 nm, 15 - 20 nm, 20 - 25 nm, 25 - 30 nm, 30 - 35 nm, or 35 - 40 nm.

The Al layer of the ohmic contact structure may be 2-5 µm, depending on the selected thickness for the first Ti layer in view of the specified condition of the ratio Ti Al < 1 - 1000.

According to one embodiment, the ohmic contact structure is arranged recessed in the Group III-Nitride material barrier layer such that the bottom of the first Ti layer extends 5-15 nm below the 2DEG channel level. This range has been identified to reduce ohmic contact. In particular, the contact resistance may be reduced even further below 0.2 ohm-mm. By extending at least 5 nm, good uniformity of contact resistance may be enabled. By not extending more than 15 nm beyond the 2DEG channel level, desirable ohmic contact may be enabled, which otherwise may result in worse ohmic contact if extending deeper. By worse ohmic contact, it may be meant 0.2-0.4 ohm-mm.

According to one embodiment, the semiconductor device structure comprises a second Ti layer arranged on the Al layer of the ohmic contact structure. The second Ti layer may function as an oxide protection layer. The second Ti layer may have a thickness of 1 - 100 nm. The second Ti layer may have a thickness of 1 - 10 nm, 10 - 20 nm, 20 - 30 nm, 30 - 40 nm, 40 - 50 nm, 50 - 60 nm, 60 - 70 nm, 70 - 80 nm, 80 - 90 nm, or 90 - 100 nm.

According to one embodiment, the semiconductor device structure comprises a passivation layer arranged on the Group III-Nitride material barrier layer, wherein the material of the passivation layer is preferably SiN. By this, the semiconductor device structure may be less affected or corroded by environment. The passivation layer may have a thickness of 1 - 400 nm. The passivation layer may have a thickness of 1 - 25 nm, 25 - 50 nm, 50 - 75 nm, 75 - 100 nm, 100 - 150 nm, 150 - 200 nm, 200 - 250 nm, 250 - 300 nm, 300 - 350 nm, 350 - 400 nm.

According to one embodiment, the material of the Group III-Nitride material channel layer is a GaN. GaN may be a preferred choice for the Group III-Nitride material channel layer because it has the highest electron mobility and velocity among the Group III-nitrides which is ideal as a channel layer in HEMT structures. The Group III-Nitride material channel layer may alternatively be AIGaN or Al graded AIGaN layers.

According to one embodiment, the material of the Group III-Nitride material barrier layer (30) is Alₓ₂Ga₁₋ₓ₂N, In_{y2}Al_{1-y2}N or In_{y2}Alₓ₂Ga_{1-x2-y2}N, x2=0-1, y2=0-1, x2+y2≤1. In the case of Alₓ₂Ga₁₋ₓ₂N, x2 may preferably be x2=0.15-1. In the case of In_{y2}Al_{1-y2}N, y2 may preferably be y2=0.1-0.2. In the case of In_{y2}Alₓ₂Ga_{1-x2-y2}N, x2, y2 may preferably be x2=0.75-0.80, y2 =0.1-0.2.

According to a second aspect of the invention, a method of manufacturing a semiconductor device structure is provided. The method comprises the steps of: providing a substrate; providing a Group III-Nitride material channel layer on the substrate; providing a Group III-Nitride material barrier layer on the Group III-Nitride material channel layer; providing a photoresist layer on the Group III-Nitride material barrier layer or optionally on a passivation layer that is provided on the Group III-Nitride material barrier layer, subjecting a target region of the photoresist layer to light to expose Group III-nitride layer or the passivation layer if provided; etching a recess in the Group III-Nitride material barrier layer to a depth beyond a 2DEG channel level provided by the Group III-Nitride material channel layer and the Group III-Nitride material barrier layer, said etching performed so that sidewalls of the Group III-Nitride material channel layer have a sidewall angle 40° ≤ θ ≤ 75°, preferably 50° ≤ θ ≤ 60°, as measured as the angle between the respective angled sidewalls and a bottom of the Group III-Nitride material barrier layer; annealing an ohmic contact structure comprising a first Ti layer and an Al layer in the recess at a temperature of 500-700°C, preferably 550-600 °C, wherein the first Ti layer is deposited by a tilting deposition process such that a thickness of the first Ti-layer is equal to or less than 5 nm; and wherein the Al layer is deposited on the Ti layer with a thickness such that a thickness ratio between the first Ti-layer and the Al-layer is Ti : Al < 1 : 1000.

By the specified sidewall angle, the tunneling distance is reduced which consequently also reduces the contact resistance. Moreover, by the first Ti layer extending below the 2DEG channel level, contact resistance is reduced further. Further, by the specified first Ti layer thickness, it results in lower contact resistance. Further, by using Ti instead of Ta in the ohmic contact structure, an even further lower contact resistance may be achieved. The ratio Ti : Al < 1 : 1000 provides the surprising advantage that the contact resistance can reduce to below 0.2 ohm-mm, which normally can only be achieved by complicated regrowth ohmic contacts.

Thus, in view of the advantages mentioned above, the semiconductor structure device solves the first object mentioned above.

The sidewall angle θ is 40° ≤ θ ≤ 75° which allows a low contact resistance. By having a steeper sidewall angle than the specified range, it may result in the difficulty of metal deposition (poor metal coverage on the sidewall). Moreover, by having a small inclination than the specified range, it may result in degradation of 2DEG concentration at the interface region of semiconductor/ohmic metals (less electrons lead to bad contact resistance). Thus, the sidewall angle may be selected accordingly with respect of these aspects. Thus, the sidewall angle θ may be selected from any of the following 40° ≤ θ ≤ 45°, 45° ≤ θ < 50°, 50° ≤ θ ≤ 55°, 55° ≤ θ ≤ 60°, 60° ≤ θ ≤ 65°, 65° ≤ θ ≤ 70°, 70° ≤ θ ≤ 75°. As an example, when the semiconductor device structure comprises an AIGaN barrier layer, a contact resistance of 0.2 ohm-mm or lower may be achieved when the sidewall angle is 50° ≤ θ ≤ 60°. However, a low contact resistance of 0.2 ohm-mm can be achieved for 40° ≤ θ ≤ 50° and 60° ≤ θ ≤ 75° by changing e.g. material of the channel layer and/or barrier layer, thicknesses thereof, properties of the ohmic contact structure etc.

The substrate may be a SiC substrate. The SiC substrate may have a polytype of 4H or 6C. The SiC substrate may be provided so that the substrate off-cut angle is substantially zero along the in-plane lattice axes. The substrate may be doped with carbon. The substrate may be semi-insulating. The substrate may be pretreated in situ or ex sity by an etching gas, such as H₂, HCl, HF, HBr or SiF₄, Cl₂ or a combination of these, such as H₂ and any one of the other. By pretreatment of the substrate, the amount of e.g. oxygen and carbon contamination onto the substrate surface may be reduced.

The Group III-Nitride material channel layer may have a thickness of 0.050 - 10 µm. The Group III-Nitride material channel layer may have a thickness of 0.050 - 0.1 µm, 0.1 - 0.2 µm, 0.2 - 0.3 µm, 0.3 - 0.4 µm, 0.4 - 0.5 µm, 0.5 - 0.6 µm, 0.6 - 0.7 µm, 0.7 - 0.8 µm, 0.8 - 0.9 µm, 0.9 - 1.0 µm, 1.0 - 2.0 µm, 2.0 - 3.0 µm, 3.0 - 4.0 µm, 4.0 - 5.0 µm, 5.0 - 6.0 µm, 6.0 - 7.0 µm, 7.0 - 8.0 µm, 8.0 - 9.0 µm, or 9.0 - 10.0 µm.

The Group III-Nitride material barrier layer may have a thickness of 1-40 nm. The Group III-Nitride material barrier layer may have a thickness of 1 - 2 nm, 2 - 3 nm, 3 - 4 nm, 4 - 5 nm, 5 - 6 nm, 6 - 7 nm, 7 - 8 nm, 8 - 9 nm, 9 - 10 nm, 10 - 15 nm, 15 - 20 nm, 20 - 25 nm, 25 - 30 nm, 30 - 35 nm, or 35 - 40 nm.

The Al layer of the ohmic contact structure may be 2-5 µm, depending on the selected thickness for the first Ti layer in view of the specified condition of the ratio Ti Al < 1 - 1000.

The semiconductor device structure may be grown using a Metal Organic Chemical Vapor Deposition (MOCVD) process or Metal Organic Vapor Phase Epitaxy (MOVPE) or Hydride Vapor Phase Epitaxy (HVPE) or Molecular Beam Epitaxy (MBE).

Growth conditions for the first and the Group III-Nitride material barrier layer, i.e. precursors used, flow rate, growth duration, pressure, temperature, temperature ramping, may be selected depending on the choice of the material for the first and Group III-Nitride material barrier layer, the optional passivation layer, and the photoresist layer.

A photoresist layer may be deposited on the Group III-Nitride material barrier layer or, if present, on the optional passivation layer. The photoresist layer may be exposed during photolithography to form undercut regions with an undercut angle.

If the optional passivation layer is present, it may be etched with inductively coupled plasma (ICP) dry etching with Fluorine-based gases. The etching may be performed without exposure to air. Etching residue may be removed by plasma ashing.

The second Group III-nitride layer may be etched with inductively coupled plasma (ICP) dry etching with Chlorine-based gases. The etching may be performed without exposure to air. Etching residue may be removed by plasma ashing.

According to one embodiment, the method comprises the step of arranging a mask accordingly to define the target region of the photoresist layer. Alternatively, the target region is exposed to light by means of a spatial light modulator.

According to one embodiment, the ohmic contact structure is annealed recessed in the Group III-Nitride material barrier layer such that the bottom of the first Ti layer extends 5-15 nm below the 2DEG channel level. By this, the contact resistance may be reduced further below 0.2 ohm-mm. By extending below 15 nm of the 2DEG channel level, it may result in poor ohmic contact, or even not ohmic contact due to poor metal coverage on the sidewall By not extending to 5 nm below the 2DEG channel level, it may result in poor uniformity of contact resistance.

According to one embodiment, the method comprises the step of providing a second Ti layer on the Al layer of the ohmic contact structure. The second Ti layer may function as an oxide protection layer. The second Ti layer may have a thickness of 1 - 100 nm. The second Ti layer may have a thickness of 1 - 10 nm, 10 - 20 nm, 20 - 30 nm, 30 - 40 nm, 40 - 50 nm, 50 - 60 nm, 60 - 70 nm, 70 - 80 nm, 80 - 90 nm, or 90 - 100 nm.

According to one embodiment, the method comprises the step of depositing a passivation layer by means of Low Pressure Chemical Vapor Deposition (LPCVD) or Plasma-enhanced chemical vapor deposition (PECVD) on the Group III-Nitride material barrier layer before being subjected to the etching step, wherein the material of the passivation layer is preferably SiN. By this, the semiconductor device structure may be less affected or corroded by environment. The passivation layer may have a thickness of 1 - 400 nm. In the case of SiN, a precursor of Silane, Dichlorosilane, and ammonia may be used. The growth conditions may be the following: the flow rate may be 50 - 400 sccm, the growth duration may be 0.1-100 minutes, the pressure may be 100 - 500 mTorr, the temperature may be 700 - 850 °C.

According to one embodiment, the material of the Group III-Nitride material channel layer is a GaN. GaN may be a preferred choice for the Group III-Nitride material channel layer because it has the highest electron mobility and velocity among the Group III-nitrides which is ideal as a channel layer in HEMT structures. The Group III-Nitride material channel layer may alternatively be AIGaN or Al graded AIGaN layers. In the case of GaN, a precursor of trimethylgallium, TMG, Ga(CH₃)₃, and ammonia, NH₃, may be used. As an example, flow rates of the precursors may be 2 l/min for NH₃ and 0.62 ml/min for TMGa. The flow rate of a carrier gas flowing through a TMGa bubbler, e.g. H₂, may be 42 ml/min. The precursors may be provided at room temperature. As an alternative at least one of the precursors may be heated in order to increase the flow rate and hence the growth rate of the GaN buffer layer. The flow of each of the precursors may be controlled by at least one mass flow controller that may be situated between the precursor container and the reactor. Each or both of the precursors may be transported by a carrier gas, such as H₂, N₂ or Ar, into the reactor. The temperature of the reactor may be about 1050 °C upon growth of the GaN layer. The pressure in the reactor upon GaN growth may be about 50 mbar. Under stable growth conditions, i.e. when e.g. temperature and pressure are stabilized, the growth rate of the GaN layer may be about 700 to 2000 nm per hour. By room temperature, it may be meant 16-23 °C.

According to one embodiment, the material of the Group III-Nitride material barrier layer is Alₓ₂Ga₁₋ₓ₂N, In_{y2}Al_{1-y2}N or In_{y2}Alₓ₂Ga_{1-x2-y2}N, x2=0-1, y2=0-1, x2+y2≤1. In the case of Alₓ₂Ga₁₋ₓ₂N, x2 may preferably be x2=0.15-1. In the case of In_{y2}Al_{1-y2}N, y2 may preferably be y2=0.1-0.2. In the case of In_{y2}Alₓ₂Ga_{1-x2-y2}N, x2, y2 may preferably be x2=0.75-0.80, y2 =0.1-0.2. The Al, Ga, In contents may be adjusted accordingly depending on growth conditions.

Precursors for growth of the Group III-Nitride material barrier layer may be TMIn, trimethylindium, i.e. In(CH₃)₃, TMAI or TEA and TMGa or TEGa. The precursors are transported, often by means of a carrier gas, such as H₂, N₂ or a mixture of N₂ and H₂, into a MOCVD reactor.

The flow rate of the carrier gas, flowing through a precursor (e.g. TMAI or TMGa) bubbler, may be about 70 ml/min for TMAI, about 50 ml/min for TMGa and 70 ml/min for TMIn. The precursor flow merges with a main carrier gas flow, which may be on the order of 30 l/min for further transport to the reactor. Reactions of the precursors form reactive intermediates and by-products take place on or in near vicinity of the substrate(s). The reactants are adsorbed on the substrate, forming a thin film layer and finally by-products are transported away from the substrate, by means of pumping on the MOCVD reactor. The pressure in a MOCVD reactor upon thin film growth normally ranges from a few mbars up to atmospheric pressure. The reactor chamber may be either cold-wall or hot-wall type. In a cold-wall reactor the substrate is typically heated from below while the reactor walls are kept cooler than the substrate. In contrast, in a hot-wall reactor the entire reactor chamber is heated, i.e. both the substrate and the reactor. For growth of the heterostructure discussed in this disclosure, a hot wall VP508GFR, AIXTRON reactor may be used. The background pressure of the reactor may be lower than 10-4 mbar. (Refs: Doping of Al-content AIGaN grown by MOCVD, PhD thesis, D. Nilsson, 2014 and Wikipedia).

According to one embodiment, the etching step involves an inductively coupled plasma, ICP, dry-etching process.

### Brief Description of the Drawings

The invention will in the following be described in more detail with reference to the enclosed drawings, wherein:
Fig. 1 shows a semiconductor device structure according to one embodiment of the invention;
Fig. 2 shows a diagram representing contact resistance as a function of annealing temperature for the present invention in relation to other known works;
Fig. 3 shows a diagram representing contact resistance as a function of recessed sidewall angle (θ in Fig. 1).
Fig. 4 shows a flow chart of a method for producing the semiconductor device structure according to one embodiment of the invention.

### Description of Embodiments

The present invention will be described more fully hereinafter with reference to the accompanying drawings, in which preferred embodiments of the invention are shown. This invention may, however, be embodied in many different forms and should not be construed as limited to the embodiments set forth herein; rather, these embodiments are provided so that this disclosure will be thorough and complete, and will fully convey the scope of the invention to those skilled in the art. In the drawings, like numbers refer to like elements.

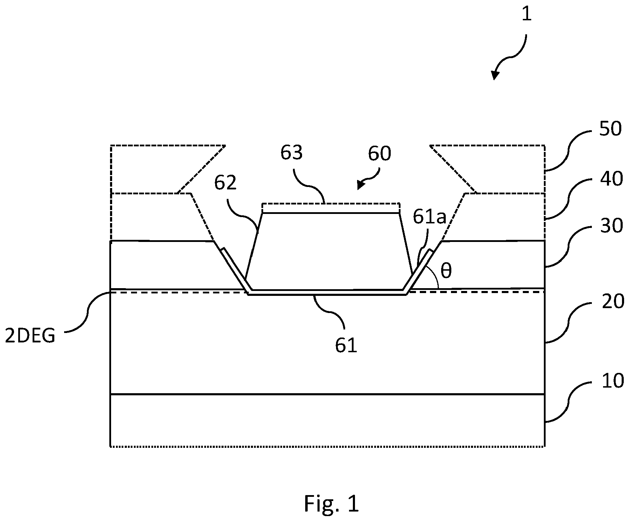

Fig. 1 shows a semiconductor device structure 1 according to one embodiment of the invention. The semiconductor device structure 1 comprises: a substrate 10; a Group III-Nitride material channel layer 20 arranged on the substrate 10; a Group III-Nitride material barrier layer 30 arranged on the Group III-Nitride material channel layer 20; an ohmic contact structure 60 comprising a first Ti layer 61 and an Al layer arranged 62 on the first Ti layer 61, wherein the ohmic contact structure 60 is arranged recessed in the Group III-Nitride material barrier layer 30 such that the bottom of the first Ti layer extends below a 2DEG channel level provided by the Group III-Nitride material channel layer and the Group III-Nitride material barrier layer 20, 30, the first Ti layer 61 provided with angled sidewalls 61a with a sidewall angle 40° ≤ θ ≤ 75° as measured as the angle between the respective angled sidewalls and a bottom of the Group III-Nitride material barrier layer 30; a thickness of the first Ti layer 61 is equal to or less than 5 nm; a thickness ratio between the first Ti layer 61 and the Al-layer 62 is Ti : Al < 1 : 1000.

Please note that the substrate 10, ohmic contact structure 60 and the various layers 20, 30, 40, 50 are not to scale.

By such a semiconductor device structure 1 as above, a low contact resistance is achieved, in particular a semiconductor device structure 1 with a contact resistance of 0.1-0.2 Ω -mm.

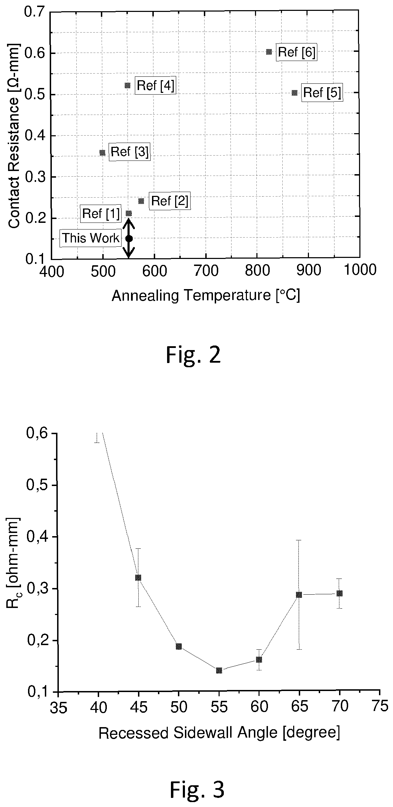

The contact resistance may be investigated as a function of annealing temperature, see Fig. 2, which shows how the present invention compares with six other inventions, namely
Ref [1]: J. Zhang et al., IEEE Electron Device Lett. 39, 847 (2018);
Ref [2]: Y. K. Lin et al., Semicond. Sci. Technol. 33, 095019 (2018);
Ref [3]: T. Yoshida and T. Egawa, Phys. Status Solidi A 215, 1700825 (2008);
Ref [4]: X. W. Wang et al., Journal of Vac. Sci. & Tech. B 38, 062206 (2020);
Ref [5]: A. Ping et al., J. Electron. Mater. 27, 261 (1998);
Ref [6]: H. S. Lee, D. S. Lee, and T. Palacios, IEEE Electron Device Lett. 32, 623 (2011).

As can be seen in Fig. 2, the contact resistance of the present invention is between 0.1-0.2 Ω-mm for an annealing temperature of 500-600 °C. For the same annealing temperature interval 500-600 °C, the invention of Ref [1] achieves roughly 0.21 Ω-mm, the invention of Ref [2] achieves roughly 0.24 Ω-mm, Ref [3] achieves 0.36 Ω-mm, and the invention of Ref [4] achieves 0.53 Ω-mm. The inventions of Ref [1], Ref [2], Ref [3], Ref [4] all fail to achieve a contact resistance of 0.2 ohm-mm or lower when using an annealing temperature of 500-600°C. The present invention allows for a low contact resistance of 0.2 ohm-mm or lower at said annealing temperature interval, thereby indicating significant improvement the present invention allows over the prior art.

Moreover, Ref [5] and Ref [6], the respective inventions achieve contact resistance of 0.5-0.6 ohm-mm at an annealing temperature of 800-900 °C and may thusly result in the Al of an AIGaN barrier layer (if present) to melt, resulting in poor surface morphology and edge acuity.

By a preferred embodiment, the semiconductor device structure may have a contact resistance of 0.15 Ω-mm. This preferred embodiment of a semiconductor device structure comprises, a SiC substrate having a cut-off angle of substantially zero along the in-plane lattice axes, a GaN layer 20 arranged on the SiC substrate 10, an AIGaN layer 30 arranged on the GaN layer 20, an ohmic contact structure 60 comprising a first Ti layer 61 and an Al layer 62 arranged on the first Ti layer 61, the ohmic contact structure 60 arranged recessed in the AIGaN layer such that the bottom of the first Ti layer 61 extends about 10 nm below a 2DEG channel level provided by the GaN layer and the AIGaN layer, the first Ti layer 61 provided with angled sidewalls 61a with a sidewall angle of about 55° as measured as the angle θ between the respective angled sidewalls 61a and a bottom of the AIGaN layer 30, the thickness of the first Ti layer 61 is about 1∼3 nm, and the thickness of the Al-layer 62 is such that the thickness ratio between the first Ti layer 61 and the Al layer 62 is Ti : Al < 1 : 1000, the thickness of the GaN layer is about 2 µm, the thickness of the AIGaN layer is about 20 nm. Moreover, the sidewall angle and the thickness of the first Ti layer are required to be optimized for different AIGaN barrier thickness and Al composition.

The semiconductor device structure may optionally comprise a second Ti layer arranged on the Al layer 62 of the ohmic contact structure 60.

The semiconductor device structure 1 may optionally comprise a SiN passivation layer 40 arranged on the AIGaN layer 30.

Fig. 3 shows a diagram representing contact resistance as a function of recessed sidewall angle θ. The ohmic contact resistance Rc measured on a sample of the semiconductor device structure as described herein comprising an AIGaN barrier layer exhibits an ohmic contact resistance Rc of >0.4 ohm-mm for sidewall angles θ less than ∼43°. It can be seen that for higher sidewall angles θ > 65°, the ohmic contact resistance Rc remains about or below 0.4 ohm-mm. An ohmic contact resistance Rc of equal to or less than 0.4 ohm-mm may be achieved when the sidewall angle 45° ≤ θ ≤ 75°. An ohmic contact resistance Rc of equal to or less than 0.2 ohm-mm may be achieved when sidewall angle is 50° ≤ θ ≤ 60°. An ohmic contact resistance of 0.2 ohm-mm at a sidewall angle of 40° ≤ θ < 50° and 60° ≤ θ < 75° may be provided by adjusting material composition of the channel layer and/or the barrier layer, thicknesses thereof, and/or ohmic contact structure properties.

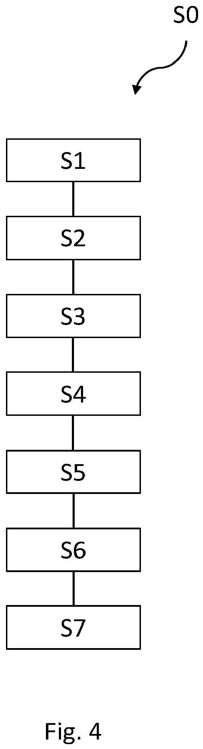

Fig. 4 shows a flow chart of a method S0 for producing the semiconductor device structure 1 according to one embodiment of the invention. The method S0 comprises the steps of providing S1 a substrate 10; providing S2 a Group III-Nitride material channel layer 20 on the substrate 1; providing S3 a Group III-Nitride material barrier layer 30 on the Group III-Nitride material channel layer 20; providing S4 a photoresist layer 50 on the Group III-Nitride material barrier layer 30 or optionally on a passivation layer that is provided on the Group III-Nitride material barrier layer 30, subjecting S5 a target region of the photoresist layer to light to expose Group III-nitride layer or the passivation layer if provided; etching S6 a recess in the Group III-Nitride material barrier layer 30 to a depth beyond a 2DEG channel level provided by the first and Group III-Nitride material barrier layers 20, 30, said etching performed so that sidewalls of the Group III-Nitride material channel layer 30 have a sidewall angle 40° ≤ θ ≤ 75° as measured as the angle θ between the respective angled sidewalls and a bottom of the Group III-Nitride material barrier layer 30; annealing S7 an ohmic contact structure 60 comprising a first Ti layer 61 and an Al layer 62 in the recess at a temperature of 500-700°C, preferably 550-600 °C, wherein the first Ti layer 61 is deposited by a tilting deposition process such that a thickness of the first Ti-layer 61 is equal to or less than 5 nm; and wherein the Al layer 62 is deposited on the Ti layer 61 with a thickness such that a thickness ratio between the first Ti-layer and the Al-layer is Ti : Al < 1 : 1000.

A sample of the semiconductor device structure with a contact resistance falling within the scope of the low ohmic contact resistance of 0.2 ohm-mm or lower was produced by the following particular steps (indicated as "This Work" in Fig. 3). In order to produce this particular sample, a SiN passivation layer 40 (see Fig. 1) was deposited on the epi-structure to protect the semiconductor from ambient air/contaminations and neutralize surface unwanted native charges (which degrades 2DEG concentration). Mesa or ion implantation were performed to define the target area for the ohmic contact structure. Then, photoresist layer 50 with an undercut (see Fig. 1) after the developing were used. The structure was then subjected to dry etching process to open the SiN passivation layer with Fluorine-based gas and then deeply recess into the epi-structure with Chlorine-based gas. An etching depth of 5∼15nm beyond 2DEG is preferred as it may reduce the contact resistance. Surface oxide at the recessed region was eliminated by wet chemical etching including Buffered oxide etchant (BOE), diluted HF, and diluted HCI just before metal deposition. Metal deposition of the first Ti layer was performed with 10 degree tilting to ensure better coverage of the metal on the recessed sidewall. The second and the third metal layer were deposited without tilting. The final step of the embodiment is lift-off unwanted metal (on the photoresist) in the acetone at 50C. The ohmic contacts were then be annealed by rapid thermal process (RTP) system at the preferred temperature of 550∼600 °C for 15∼90 mins depended on the thickness of the AIGaN barrier and ohmic metal.

In the drawings and specification, there have been disclosed preferred embodiments and examples of the invention and, although specific terms are employed, they are used in a generic and descriptive sense only and not for the purpose of limitation, the scope of the invention being set forth in the following claims.

## Claims

1. A semiconductor device structure (1) comprising:
a substrate (10);
a Group III-Nitride material channel layer (20) arranged on the substrate (10);
a Group III-Nitride material barrier layer (30) arranged on the Group III-Nitride material channel layer (20);
an ohmic contact structure (60) comprising a first Ti layer (61) and an Al layer (62) arranged on the first Ti layer (61),
wherein the ohmic contact structure (60) is arranged recessed in the Group III-Nitride material barrier layer (30) such that the bottom of the first Ti layer (61) extends below a 2DEG channel level (2DEG) provided by the Group III-Nitride material channel layer and Group III-Nitride material barrier layer (20, 30),
the first Ti layer (61) provided with angled sidewalls (61a) with a sidewall angle 40° ≤ θ ≤ 75°, preferably 50° ≤ θ ≤ 60°, as measured as the angle (θ) between the respective angled sidewalls (61a) and a bottom of the Group III-Nitride material barrier layer (30);
a thickness of the first Ti layer (61) is equal to or less than 5 nm;
a thickness ratio between the first Ti layer (61) and the Al-layer (62) is Ti : Al < 1 : 1000.

2. Semiconductor device structure (1) according to claim 1, wherein the ohmic contact structure (60) is arranged recessed in the Group III-Nitride material barrier layer (30) such that the bottom of the first Ti layer (61) extends 5-15 nm below the 2DEG channel level (2DEG).

3. Semiconductor device structure (1) according to any of claims 1-2, comprising a second Ti layer (63) arranged on the Al layer (62) of the ohmic contact structure (60).

4. Semiconductor device structure (1) according to any of claims 1-3, comprising a passivation layer (40) arranged on the Group III-Nitride material barrier layer (30), wherein the material of the passivation layer (40) is preferably SiN.

5. Semiconductor device structure (1) according to any preceding claims, wherein the material of the Group III-Nitride material channel layer (20) is a GaN.

6. Semiconductor device structure (1) according to any preceding claims, wherein the material of the Group III-Nitride material barrier layer (30) is Alₓ₂Ga₁₋ₓ₂N, In_{y2}Al_{1-y2}N or In_{y2}Alₓ₂Ga_{1-x2-y2}N, x2=0-1, y2=0-1, x2+y2≤1.

7. Method (S0) of manufacturing a semiconductor device structure (1), comprising the steps of:
providing (S1) a substrate (10);
providing (S2) a Group III-Nitride material channel layer (20) on the substrate (1);
providing (S3) a Group III-Nitride material barrier layer (30) on the Group III-Nitride material channel layer (20);
providing (S4) a photoresist layer (50) on the Group III-Nitride material barrier layer (30) or optionally on a passivation layer that is provided on the Group III-Nitride material barrier layer (30),
subjecting (S5) a target region of the photoresist layer to light to expose Group III-nitride layer or the passivation layer if provided;
etching (S6) a recess in the Group III-Nitride material barrier layer (30) to a depth beyond a 2DEG channel level (2DEG) provided by the Group III-Nitride material channel layer and Group III-Nitride material barrier layer (20, 30), said etching performed so that sidewalls of the Group III-Nitride material channel layer (30) have a sidewall angle 40° ≤ θ ≤ 75°, preferably 50° ≤ θ ≤ 60°, as measured as the angle (θ) between the respective angled sidewalls and a bottom of the Group III-Nitride material barrier layer (30);
annealing (S7) an ohmic contact structure (60) comprising a first Ti layer (61) and an Al layer (62) in the recess at a temperature of 500-700°C, preferably 550-600 °C,
wherein the first Ti layer (61) is deposited by a tilting deposition process such that a thickness of the first Ti-layer (61) is equal to or less than 5 nm; and
wherein the Al layer (62) is deposited on the Ti layer (61) with a thickness such that a thickness ratio between the first Ti-layer and the Al-layer is Ti : Al < 1 : 1000.

8. Method according to claim 7, comprising the step of arranging a mask accordingly to define the target region of the photoresist layer.

9. Method according to claim 7, wherein the target region is exposed to light by means of a spatial light modulator.

10. Method according to any of claims 7-9, wherein the ohmic contact structure (60) is annealed recessed in the Group III-Nitride material barrier layer (30) such that the bottom of the first Ti layer (61) extends 5-15 nm below the 2DEG channel level (2DEG).

11. Method according to any of claims 7-10, comprising the step of providing a second Ti layer (62) on the Al layer (62) of the ohmic contact structure (60).

12. Method according to any of claims 7-11, comprising the step of depositing a passivation layer (40) by means of LPCVD or PECVD on the Group III-Nitride material barrier layer (30) before being subjected to the etching step, wherein the material of the passivation layer (40) is preferably SiN.

13. Method according to any of claims 7-12, wherein the material of the Group III-Nitride material channel layer (20) is a GaN.

14. Method according to any of claims 7-13, wherein the material of the Group III-Nitride material barrier layer (30) is Alₓ₂Ga₁₋ₓ₂N, In_{y2}Al_{1-y2}N or In_{y2}Alₓ₂Ga₁₋ x2-y2N, x2=0-1, y2=0-1, x2+y2≤1.

15. Method according to any of claims 7-14, wherein the etching step involves a ICP dry-etching process.
